# EUROPEAN PATENT SPECIFICATION

(11) **EP 3 373 332 B1**
(45) Date of publication and mention of the grant of the patent: **31.03.2021**
(21) Application number: 18152659.1
(22) Date of filing: 19.01.2018
(51) Int. Cl.: H01L 25/065, H01L 23/538, H01L 23/00, H01L 25/18

(54) **EMBEDDED MULTI-DIE INTERCONNECT BRIDGE WITH IMPROVED POWER DELIVERY**
EINGEBETTETE MULTICHIP-VERBINDUNGSBRÜCKE MIT VERBESSERTER STROMABGABE
PONT D'INTERCONNEXION MULTIMATRICE INTÉGRÉ AYANT UNE DISTRIBUTION D'ÉNERGIE AMÉLIORÉE

(30) Priority: 22.02.2017 US 201715439118
(43) Date of publication of application: 12.09.2018
(60) Divisional application: 20216817.5
(73) Proprietor: INTEL Corporation, Santa Clara, CA 95054 (US)
(72) Inventor: LIU, Hui, Santa Clara, CA 95054 (US); OH, Kyung Suk, Jungja-Dong Michellan Sherville D-1404 (US)
(74) Representative: Goddar, Heinz J.

(56) References cited:
- JP-A- 2001 168 531
- US-A1- 2001 052 647
- US-A1- 2015 279 817
- US-B1- 9 129 935
- US-B1- 9 368 450

## Description

### Background

This relates generally to integrated circuit packages, and more particularly, to integrated circuit packages with embedded multi-die interconnect bridges (EMIBs) that connect more than one integrated circuit die.

An integrated circuit package typically includes an integrated circuit die and a substrate on which the die is mounted. The die can be coupled to the substrate through bonding wires or solder bumps. Signals from the integrated circuit die may then travel through the bonding wires or solder bumps to the substrate.

As demands on integrated circuit technology continue to outstrip even the gains afforded by ever decreasing device dimensions, more and more applications demand a packaged solution with more integration than possible in one silicon die. In an effort to meet this need, more than one die may be placed within a single integrated circuit package (i.e., a multichip package). As different types of devices cater to different types of applications, more dies maybe required in some systems to meet the requirements of high performance applications. Accordingly, to obtain better performance and higher density, an integrated circuit package may include multiple dies arranged laterally along the same plane.

EMIBs are small silicon dies that are sometimes embedded in the substrate of a multichip package and are used to interconnect integrated circuit dies within that multichip package. Traditionally, these EMIBS have limited power delivery capability compared to other interposer technologies such as silicon interposers.

It is within this context that the embodiments described herein arise.

US 9368450 B1 describes an integrated device package which includes a first die, a second die, an encapsulation portion coupled to the first die and the second die, and a redistribution portion coupled to the encapsulation portion. The encapsulation portion includes an encapsulation layer, a bridge, and a first via. The bridge is at embedded in the encapsulation layer. The bridge is configured to provide a first electrical path for a first signal between the first die and the second die. The first via is in the encapsulation layer. The first via is coupled to the bridge. The first via and the bridge are configured to provide a second electrical path for a second signal to the first die. The redistribution portion includes at least one dielectric layer, and at least one interconnect, in the dielectric layer, coupled to the first via.

US 2015/279817 A1 describes an apparatus including a package substrate including a plurality of layers of conductive material, the package substrate including a cavity; and a device in the cavity. An ultimate layer of the layers of conductive material defines contacts to contact points of the device. A silicon bridge die is disposed between conductive layers and an ultimate layer of the plurality of conductive layers defines contact points to contact points of the silicon bridge die; and a logic die coupled to the contact points of the ultimate layer of the plurality of layers of conductive layers.

US 2001/052647 A1 describes an integrated circuit package which comprises a flexible circuit that is laminated to a stiffener using a dielectric adhesive, with the conductive traces on the flexible circuit facing toward the stiffener but separated therefrom by the adhesive. The conductive traces include an array of flip-chip attachment pads. A window is formed in the stiffener over the attachment pad array, such as by etching. The adhesive is then removed over the attachment pads by laser ablation, but left in place between the pads, thus forming a flip-chip attachment site.

JP 2001168531 a describes a multilayer printed wiring board such that a large-diameter through hole at an outer peripheral part is a signal line. A small-diameter through hole at a central part is a power source line and ground line, thus arraying multiple power source lines and ground lines and shortening the wiring length from an IC chip to a second board. In this regard, the inductance component of the power source line and ground line to the IC chip is reduced.

The invention is defined in independent claim 1. Embodiments of the invention are described in the dependent claims.

### Summary

An integrated circuit package may include a package substrate and one or more integrated circuit dies mounted on the package substrate. The package substrate may include an embedded multi-die interconnect bridge (EMIB) embedded within the package substrate. An EMIB is a silicon die that may be used to interconnect two integrated circuits in a multi-chip package. The integrated circuit dies mounted on the package substrate may communicate with one another through the EMIB. The EMIB may have a front side that faces the integrated circuit dies and a back side that opposes the front side. The package substrate may include a conductive path that is electrically coupled to the EMIB from the back side of the EMIB and that supplies power to the EMIB. The package substrate may be mounted on a printed circuit board that provides power to the EMIB through the conductive path.

The package substrate may also include a conductive layer (e.g., back side conductor) on which the EMIB is mounted. The conductive path may be connected to the conductive layer and may provide power to the EMIB through the conductive layer. A patterned adhesive layer may be applied to the conductive layer before the EMIB is mounted on the conductive layer and may include openings that accommodate conductive pads (e.g., contact pads) formed at the back side of the EMIB. In other words, once the EMIB is mounted on the conductive layer, the patterned adhesive layer may laterally surround the conductive pads formed at the back side of the EMIB. Additional contact pads may be formed at the front side of the EMIB.

The package substrate may include a first via directly connected to a contact pad formed at the front side of the EMIB, and may include a second via that is coupled to a contact pad formed at the back side of the EMIB through the conductive layer. The second via may have a diameter that is greater than a diameter of the first via.

The EMIB may include a conductive routing trace (e.g., interconnect) that is coupled to the integrated circuit dies. A microvia formed in the EMIB may be coupled between one of the conductive pads formed at the back side of the EMIB and the conductive routing trace. Power supply voltage signals or data signals may be provided to the conductive routing trace through the microvia.

The EMIB may include multiple through-silicon vias that extend from the back side of the EMIB to the front side of the EMIB. These through-silicon vias may be used to transfer power or data signals from the conductive path to the integrated circuit dies through the EMIB.

The conductive layer may include multiple conductive regions that are electrically isolated from one another. Each region of the conductive layer may receive a different power supply voltage signal or data signal from each other region of the conducive layer.

Fabricating an integrated circuit package may include multiple processing steps. A first dielectric layer may be formed. A via may be formed through the first dielectric layer. A conductive layer may be formed on the first dielectric layer in direct physical contact with the via. Forming the conductive layer may involve forming multiple conductive regions that are electrically isolated from one another. A silicon die (e.g., an EMIB) may be mounted on the conductive layer. Additional dielectric layers may be formed covering the silicon die. A first integrated circuit die may be mounted on the additional dielectric layers. A second integrated circuit die may be mounted on the additional dielectric layers. The silicon die may include a conductive routing trace that couples the first integrated circuit die to the second integrated circuit die.

Before forming the additional dielectric layer, a second dielectric layer may be formed on the first dielectric layer. A cavity may be formed in the second dielectric layer directly over the conductive layer. Mounting the silicon die on the conductive layer may include inserting the silicon die into the cavity. A patterned adhesive layer may be formed between the silicon die and the conductive layer. The patterned adhesive die may include a plurality of openings to accommodate contact pads formed on a bottom surface of the silicon die.

Further features of the present invention, its nature and various advantages will be more apparent from the accompanying drawings and the following detailed description.

### Brief Description of the Drawings

FIG. 1 is a diagram of an illustrative system of integrated circuit devices operable to communicate with one another in accordance with an embodiment.
FIG. 2 is a diagram of an illustrative multichip package in accordance with an embodiment.
FIG. 3 is a cross-sectional side view of an illustrative multichip package that includes two die coupled together using an embedded multi-die interconnect bridge (EMIB) in accordance with an embodiment.
FIG. 4 is a top view of an illustrative multichip package that includes two die coupled together using an EMIB in accordance with an embodiment.
FIG. 5 is a cross-sectional side view of an illustrative multichip package that includes an EMIB having through-silicon vias in accordance with an embodiment.
FIG. 6 is a cross-sectional side view of an illustrative EMIB having internal microvias in accordance with an embodiment.
FIG. 7A is a top view of an illustrative back side conductor for an EMIB that is horizontally separated into three voltage regions that are electrically isolated from one another in accordance with an embodiment.
FIG. 7B is a top view of an illustrative conductive back side conductor for an EMIB that is vertically separated into three voltage regions in accordance with an embodiment.
FIG. 7C is a top view of an illustrative conductive back side conductor that is separated into three voltage regions and two signal regions, which are all electrically isolated from each other in accordance with an embodiment.
FIG. 8 is a flow chart showing illustrative steps for forming a package substrate that includes an EMIB with improved power delivery capabilities in accordance with an embodiment.

### Detailed Description

Embodiments of the present invention relate to integrated circuits, and more particularly, to ways of improving power delivery through an embedded multi-die interconnect bridge in a multichip package.

As integrated circuit fabrication technology scales towards smaller process nodes, it becomes increasingly challenging to design an entire system on a single integrated circuit die (sometimes referred to as a system-on-chip). Designing analog and digital circuitry to support desired performance levels while minimizing leakage and power consumption can be extremely time consuming and costly.

One alternative to single-die packages is an arrangement in which multiple dies are placed within a single package. Such types of packages that contain multiple interconnected dies may sometimes be referred to as systems-in-package (SiPs), multi-chip modules (MCM), or multichip packages. Placing multiple chips (dies) into a single package may allow each die to be implemented using the most appropriate technology process (e.g., a memory chip may be implemented using the 28 nm technology node, whereas the radio-frequency analog chip may be implemented using the 45 nm technology node), may increase the performance of die-to-die interface (e.g., driving signals from one die to another within a single package is substantially easier than driving signals from one package to another, thereby reducing power consumption of associated input-output buffers), may free up input-output pins (e.g., input-output pins associated with die-to-die connections are much smaller than pins associated with package-to-board connections), and may help simplify printed circuit board (PCB) design (i.e., the design of the PCB on which the multi-chip package is mounted during normal system operation).

In order to facilitate communications between two chips on a multi-chip package, the package may include an embedded multi-die interconnect bridge (EMIB) that is designed and patented by INTEL Corporation. An EMIB is a small silicon die that is embedded in the underlying substrate of a multi-chip package and that offers dedicated ultra-high-density interconnection between dies within the package. EMIBs generally include wires of minimal length, which help to significantly reduce loading and directly boost performance.

EMIB solutions may be advantageous over other multi-chip packaging schemes that use a silicon interposer, which is prone to issues such as warpage and requires a comparatively large number of microbumps and through-silicon vias (TSVs) to be formed on and within the interposer, thereby reducing overall yield and increasing manufacturing complexity and cost. The number of dies that can be integrated using an interposer is also limited to that supported by EMIB technology.

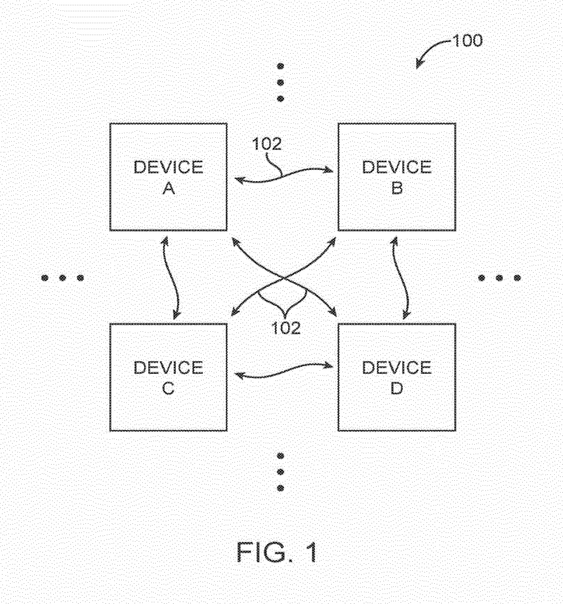

The EMIB technology described above may be used as an interface between one or more integrated circuit dies in a system. FIG. 1 is a diagram of an illustrative system 100 of interconnected electronic devices. The system of interconnected electronic devices may have multiple electronic devices such as device A, device B, device C, device D, and interconnection resources 102. Interconnection resources 102 such as conductive lines and busses, optical interconnect infrastructure, or wired and wireless networks with optional intermediate switching circuitry may be used to send signals from one electronic device to another electronic device or to broadcast information from one electronic device to multiple other electronic devices. For example, a transmitter in device B may transmit data signals to a receiver in device C. Similarly, device C may use a transmitter to transmit data to a receiver in device B.

The electronic devices may be any suitable type of electronic device that communicates with other electronic devices. Examples of such electronic devices include basic electronic components and circuits such as analog circuits, digital circuits, mixed-signal circuits, circuits formed within a single package, circuits housed within different packages, circuits that are interconnected on a printed-circuit board (PCB), etc.

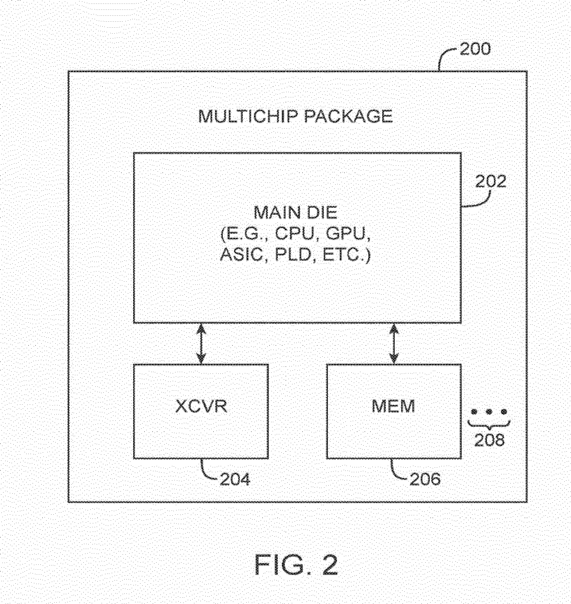

As shown in FIG. 2, a multi-chip package 200 may include a main die 202, a transceiver die 204, a memory die 206, and additional auxiliary dies 208. Main die 202, for example, may be a central processing unit (CPU), a graphics processing unit (GPU), an application-specific integrated circuit (ASIC), a programmable logic device (PLD), or any other desired processor or logic device. Secondary integrated circuit dies such as transceiver die 204, memory die 206, and auxiliary dies 208 may be coupled to main die 202 and may communicate with main die 202. Memory die 206, for example, may be an erasable-programmable read-only memory (EPROM) chip, a non-volatile memory (e.g., 3D XPoint) chip, a volatile memory (e.g., high bandwidth memory) chip, or any other suitable memory device. Auxiliary dies 208 may include additional memory dies, transceiver dies, programmable logic devices, and any other suitable integrated circuit devices.

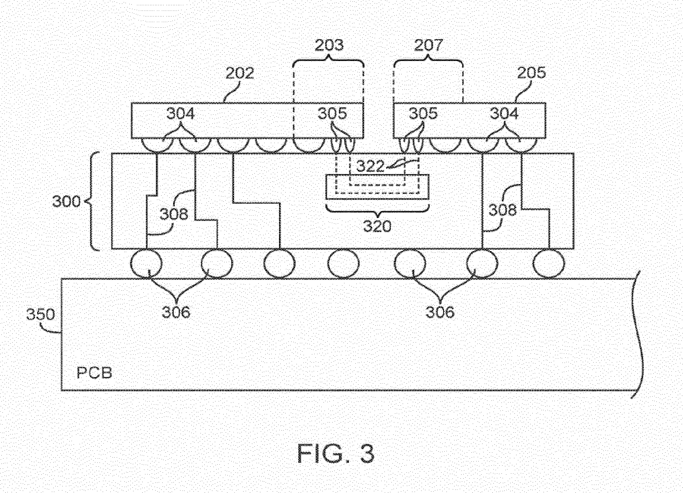

An EMIB may be embedded in a multi-chip package to connect two adjacent integrated circuit dies on the package. As shown in FIG. 3, main die 202 and secondary die 205 may be mounted onto package substrate 300 using solder bumps 304 and solder microbumps 305. Package substrate 300 may be mounted onto printed circuit board (PCB) 350 using solder (e.g., solder balls, solder bumps) 306. The terms solder "balls" or solder "bumps" may sometimes be use interchangeably. Signals (e.g., data signals and power supply voltage signals) may be transferred between PCB 350 and dies 202 and 205 through solder balls 306, package vias 308 in package 300, and solder bumps 304.

Main die 202 may be coupled to a secondary die 205 using EMIB 320 that is embedded in package substrate 300. Signals being passed between main die 202 and secondary die 205 may pass through interconnects (e.g., conductive paths) 322 and microbumps 305. EMIB 320 may have a front side that faces main die 202 and secondary die 205 and may have a back side that faces package substrate 300. An EMIB is traditionally formed on a solid, electrically floating conductive plate for structural support. It is therefore difficult to provide power to microbumps 305 that overlap with regions 203 and 207 of main die 202 and secondary die 205, as power cannot be delivered vertically from the PCB through the EMIB to regions 203 and 207 because back side routing is blocked by the conductive plate.

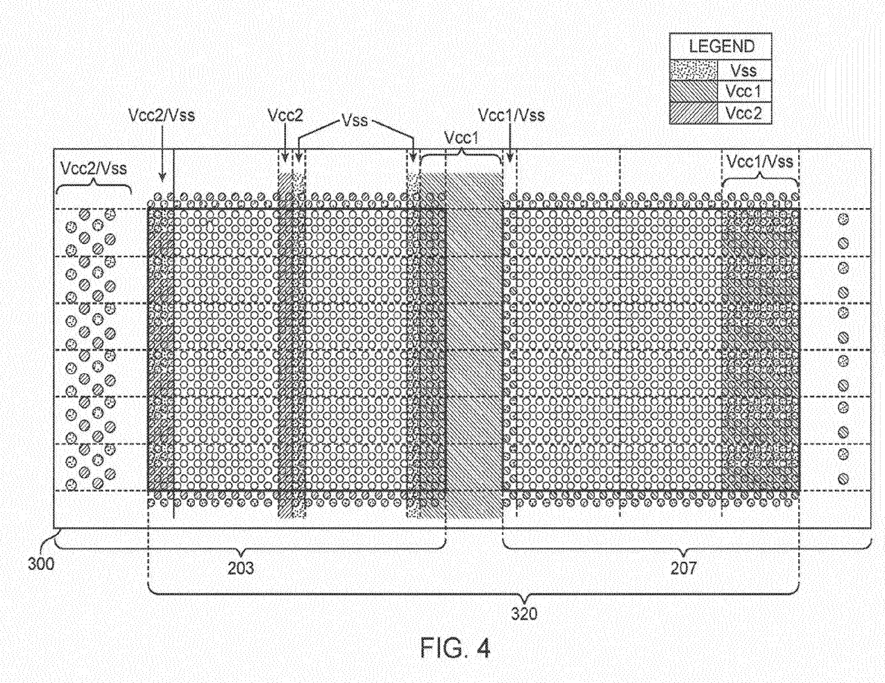

FIG. 4 shows a top view of package substrate 300 in regions 203 and 207 and illustrates possible means of power and ground signal delivery to microbump arrays in regions 203 and 207. Two microbump arrays in regions 203 and 207 may overlap with EMIB 320 formed in package substrate 300. Each microbump array, for example, may correspond to an edge of an integrated circuit die (e.g., main die 202 and secondary die 205 of FIG. 3). Three different voltage signals may be applied to the pads of package substrate 300: (1) a common voltage signal Vss (e.g., ground power supply voltage signal), (2) a power supply voltage signal Vcc1 for region 207 (e.g., for secondary die 205 in FIG. 3), and a power supply voltage signal Vcc2 for region 203 (e.g., for main die 202 of FIG. 3). It should be noted that a portion of the microbumps in region 203 may also receive power supply voltage signal Vcc1.

These power supply and common voltage signals may be delivered to peripheral microbumps in regions 203 and 207 without exceptional loss in power efficiency. For example, voltage signals Vss, Vcc1, and Vcc2 may be delivered to the microbumps at the edges of the microbump arrays of regions 203 and 207 using conductors (e.g., copper traces) formed in a top layer of the package substrate.

Additionally, microbumps in the center (e.g., not at the periphery) of the microbump arrays of regions 203 and 207 may have voltage signals Vss, Vcc1, and Vcc2 routed to them by forming conductors (e.g., copper traces) in a top layer of the package substrate arranged to extend vertically across a given microbump array. Only microbumps in the path of one of these conductors may receive the respective voltage signal carried by that conductor. However, extending one of these conductors to cover the entire width of a microbump array may undesirably result in a loss in power efficiency. It would therefore be advantageous to provide alternate means of power delivery for microbumps in the center of the microbump arrays of regions 203 and 207.

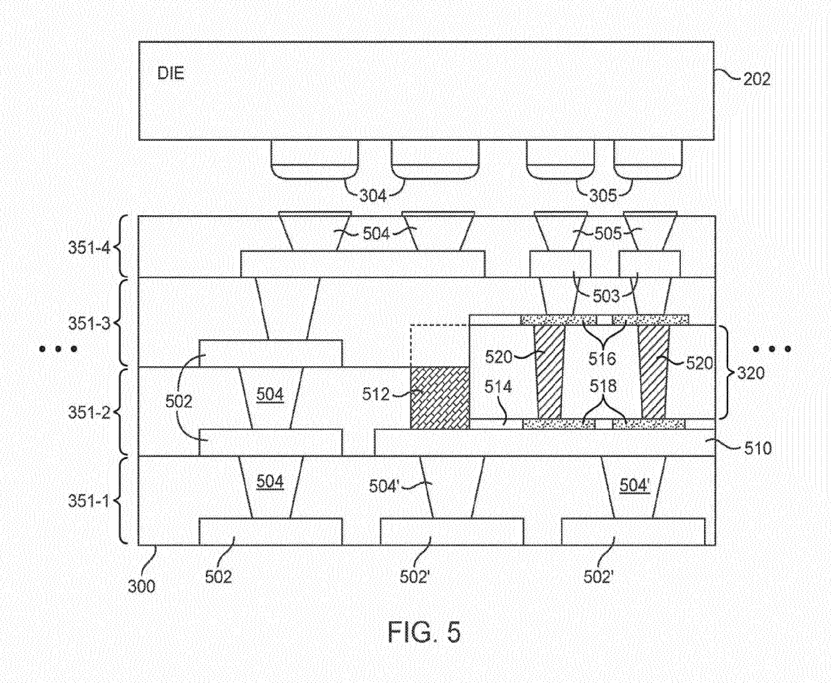

One alternative to the topside microbump power delivery described above is to deliver power and ground signals to the microbumps from the PCB vertically through the package substrate and the EMIB from the back side. As shown in FIG. 5, main die 202 may be mounted onto package substrate 300 using solder bumps (e.g., controlled collapse chip connection (C4) bumps) 304 and microbumps 305. It should be noted that the pitch width of solder bumps 304 may be greater than the pitch width of microbumps 305, such that microbumps 305 have greater connection density than solder bumps 304. The diameter of microbumps 305 are also generally smaller than the diameter of C4 bumps 304 (e.g., bumps 305 may be at least two times smaller, at least four times smaller, etc.)

Solder bumps 304 may be provided with signals (e.g., data signals or power supply voltage signals) from a printed circuit board (e.g., PCB 350 of FIG. 3) through vias 504 and traces 502 formed in routing layers 351-1, 351-2, 351-3, and 351-4 of package substrate 300. If desired, the package substrate may include additional layers (e.g., the number of layers in the package substrate is not limited to four).

Microbumps 305 may be provided with signals (e.g, data signals or power supply voltage signals) from EMIB 320 through vias 505 and traces 503. The signals provided to microbumps 305 may be received from another chip coupled to EMIB 302 or from a PCB (e.g., PCB 350 of FIG. 3) on which package substrate 300 is mounted. It should be noted that vias 505 may be smaller than vias 504 and vias 504'.

EMIB 320 may be mounted on a back side conductor (e.g., conductive layer or copper conductive layer) 510 in layer 351-2 of package substrate 300 using an adhesive layer 514 during fabrication of package substrate 300. A cavity 512 may be included adjacent to EMIB 320 in order to account for differences between the coefficient of thermal expansion between EMIB 320 and package substrate 300, which may reduce thermal stresses placed on EMIB 320.

EMIB 320 may include through-silicon vias (TSVs) that extend vertically from the front side of EMIB 320 to the back side of EMIB 320 to connect contact pads 516 formed on the front side of EMIB 320 to contact pads 518 formed on the back side of EMIB 320. Adhesive layer 514 may be patterned to accommodate contact pads 518 to ensure that contact pads 518 are in electrical contact with back side conductor 510. In other words, adhesive layer 514 may laterally surround contact pads 518 of EMIB 320 without being interposed between contact pads 518 and back side conductor 510.

In accordance with an embodiment, back side conductor 510 may receive power supply voltage signals and/or data signals from a PCB (e.g., PCB 350 of FIG. 3) through vias 504' and traces 502' and may provide these signals to contact pads 518 of EMIB 320. It should be noted that vias 504' may have a diameter that is larger than the diameter of vias 505. Having a larger diameter allows vias 504' to carry more power than would be achievable with vias having a comparatively smaller diameter.

By providing signals to EMIB 320 from the PCB through back side conductor 510, vias 504', and traces 502', and providing power to one or both circuit dies through TSVs 520 in EMIB 320, vertical power distribution may be achieved through EMIB 320.

Conventional EMIB arrangements lack such back side vertical power distribution paths and instead are limited to passing power between chips connected by the EMIB over the EMIB itself or by routing power to these chips around the EMIB. Both of these conventional power distribution options disadvantageously reduce power efficiency of the system containing the EMIB by requiring smaller gauge traces or longer traces for power delivery compared to the vertical power distribution path coupled to EMIB 320.

Thus, the vertical power distribution path coupled between the PCB and the back side of EMIB 320 that includes back side conductor 510, vias 504', and traces 502' is advantageous over these conventional EMIB arrangements in terms of power efficiency.

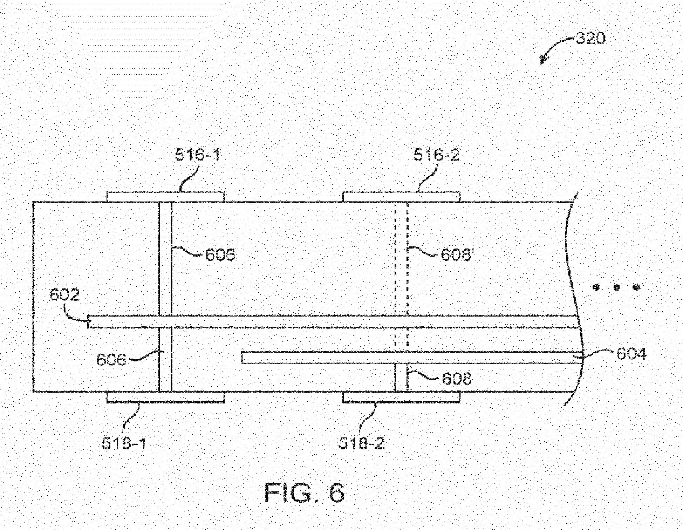

Signals may also be provided from the PCB to internal interconnects of EMIB 320. As shown in FIG. 6, EMIB 320 may include interconnects (e.g., conductive routing traces) 602 and 604. Contact pads 518-1 and 518-2 may receive power supply voltage signals, ground voltage signals, or data signals (e.g., from back side conductor 510 of FIG. 5), and may pass these signals to EMIB microvias 606 and 608. Microvia 606 may include a portion interposed between interconnect 602 and contact pad 518-1, such that signals received by contact pad 518-1 may be passed to interconnect 602. Microvia 606 may also include a portion interposed between interconnect 602 and contact pad 516-1, such that signals received by contact pad 518-1 may also be passed to contact pad 516-1 and thereby to any microbumps coupled to contact pad 516-1.

Microvia 608 may only extend from contact pad 518-2 to interconnect 604. Contact pad 518-2 may pass received signals to interconnect 604 through microvia 608. Optionally, an additional microvia 608' may be interposed between interconnect 602 and interconnect 604 and/or may be interposed between contact pad 516-2 and interconnect 602. This arrangement allows for signals received by contact pad 518-2 to be passed to each of interconnects 602 and 604 and to contact pad 516-2 and thereby to any microbumps coupled to contact pad 516-2.

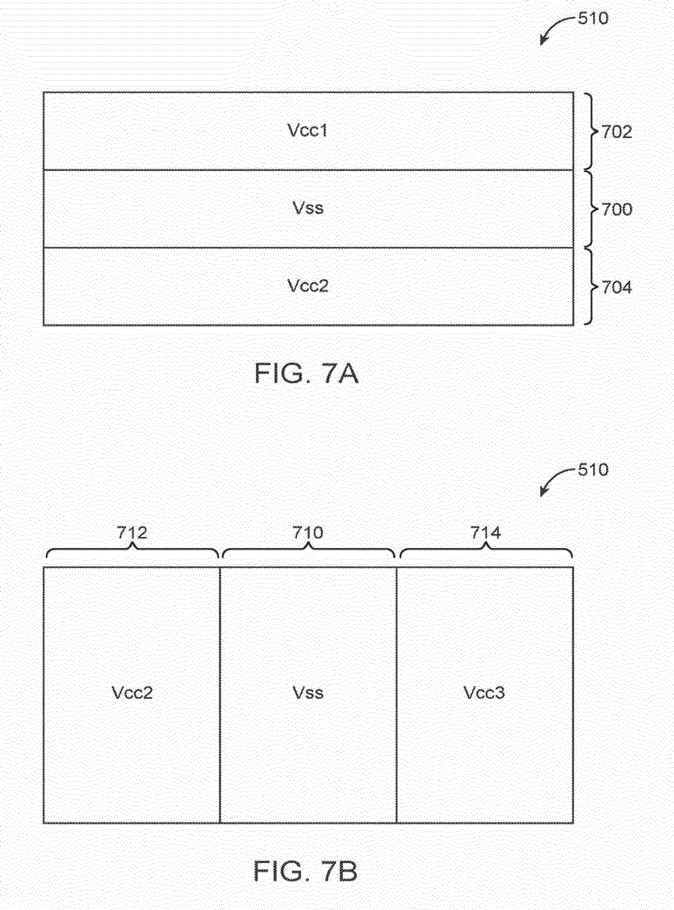

If desired, back side conductor 510 of FIG. 5 may be separated into multiple regions that are electrically isolated from one another, where each region may receive a different power supply voltage signal, ground voltage signal, or data signal from the PCB. Some possible arrangements of back side conductor 510 are described below in connection with FIGS. 7A-7C.

As shown in FIG. 7A, back side conductor 510 may be horizontally separated into regions 700, 702, and 704 that are each electrically isolated from one another. Power supply voltage signal Vcc1 may be applied to region 702. Common (e.g., ground) power supply voltage signal Vss may be applied to region 700. Power supply voltage signal Vcc2 may be applied to region 704. This arrangement of back side conductor 510 allows for the three different types of power/ground voltage signals to be applied to the microbumps of either of the two chips connected to one another through the EMIB (e.g., EMIB 320) attached to back side conductor 510.

As shown in FIG. 7B, back side conductor 510 may be vertically separated into regions 710, 712, and 714 that are each electrically isolated from one another. Power supply voltage signal Vcc2 may be applied to region 712. Common (e.g., ground) power supply voltage signal Vss may be applied to region 710. Power supply voltage signal Vcc3 may be applied to region 714. This arrangement of back side conductor 510 allows for power supply voltage signal Vcc2 to be applied to the microbumps of one of the two chips connected to one another through the EMIB (e.g., EMIB 320) attached to back side conductor 510, for power supply voltage signal Vcc3 to be applied to the microbumps of the other chip of the two chips, and for common signal Vss to be applied to either or both of the two chips.

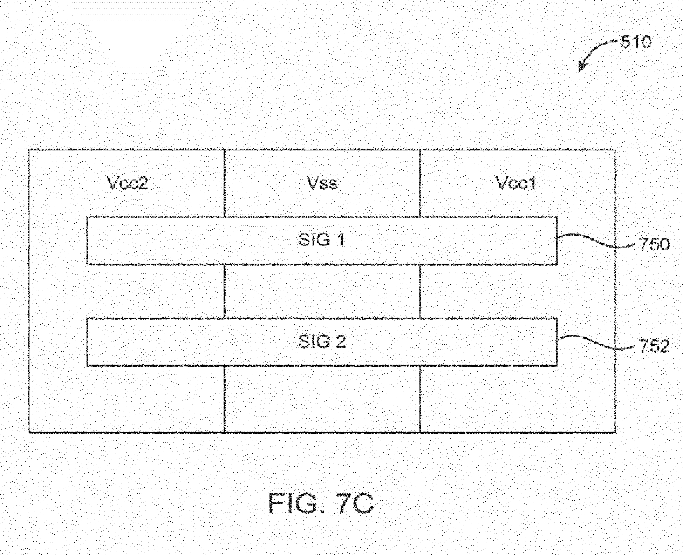

As shown in FIG. 7C, back side conductor 510 may be separated into three vertically separated regions that are each electrically isolated from one another, similar to the arrangement of FIG. 7B. Each vertically separated region may receive one of power supply voltage signal Vcc1, power supply voltage signal Vcc2, and common signal Vss. Back side conductor 510 may further include two horizontal regions 750 and 752 that are electrically isolated from one another and from the three separated vertical regions. Data signal SIG1 may be applied to region 750 and data signal SIG 2 may be applied to region 752. In this way, data signals may also be passed to the EMIB (e.g., EMIB 320) that is mounted on back side conductor 510.

The arrangements of back side conductor 510 shown in FIGS. 7A-C are merely illustrative. If desired, back side conductor 510 may include any number of regions that are electrically isolated from one another and that each receive a different power supply voltage signal or data signal (e.g., from a printed circuit board).

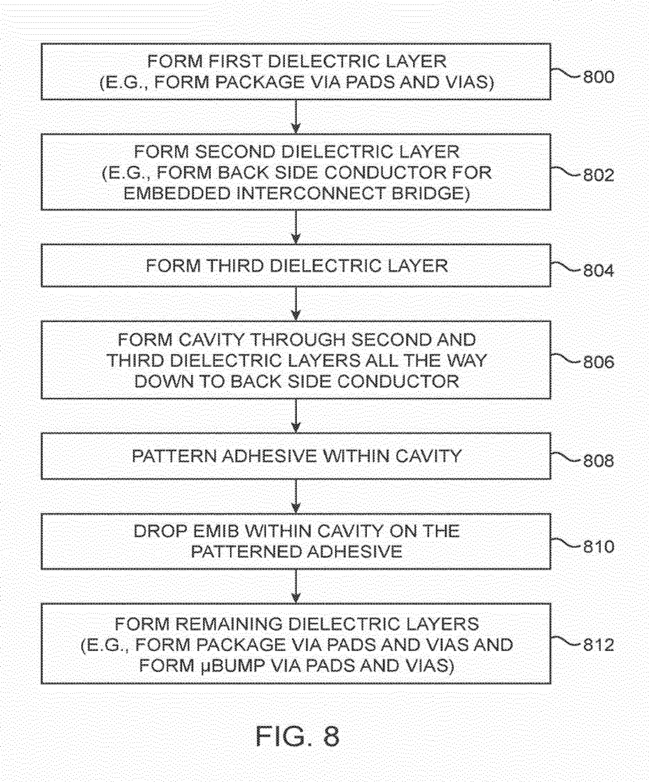

FIG. 8 shows the illustrative steps performed when manufacturing package substrate 300 of FIG. 5.

At step 800, first dielectric layer 351-1 may be formed. Vias 504 and 504' in layer 351-1 and traces 502 and 502' may also be formed at this step.

At step 802, second dielectric layer 351-2 may be formed. Via 504, trace 502, and back side conductor 510 may also be formed in layer 351-2 at this step. As described in connection with FIGS. 7A-7C above, back side conductor 510 may be formed having multiple regions that are electrically isolated from one another and that each receive a different power supply voltage signal or data signal.

At step 804, third dielectric layer 351-3 may be formed. Via 504 and trace 502 may be formed in layer 351-3 at this step.

At step 806, A cavity may be formed in second dielectric layer 351-2 and third dielectric layer 351-3 (e.g., using photolithographic etching, lapping, or drilling). The cavity may overlap back side conductor 510 and may extend through layers 351-2 and 351-3 so as to expose back side conductor 510.

At step 808, adhesive layer 514 may be patterned within the cavity, such that openings are formed in adhesive layer 514 to accommodate contact pads 518 of EMIB 320.

At step 810, EMIB 320 may be placed on the patterned adhesive within the cavity, and may thereby be mounted on back side conductor 510. It should be noted that any TSVs or internal EMIB microvias may already be formed within EMIB 320 prior to the placement of EMIB 320 in the cavity (e.g., during fabrication of EMIB 320).

At step 812, remaining dielectric layers including dielectric layer 851-4 and the portion of dielectric layer 851-3 disposed over EMIB 320 may be formed. Vias 504 and 505 and traces (e.g., via pads) 502 and 503 may also be formed at this step.

Optionally, step 804 may be omitted and the entirety of layer 851-3 may be formed during step 812. In this optional case, the cavity only needs to be formed in second dielectric layer 851-2 during step 806.

The embodiments thus far have been described with respect to integrated circuits. The methods and apparatuses described herein may be incorporated into any suitable circuit. For example, they may be incorporated into numerous types of devices such as programmable logic devices, application specific standard products (ASSPs), and application specific integrated circuits (ASICs). Examples of programmable logic devices include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The foregoing is merely illustrative of the principles of this invention and various modifications can be made by those skilled in the art.

## Claims

1. An integrated circuit package, comprising:
a package substrate (300); and
an integrated circuit die (202) mounted on the package substrate (300), wherein the package substrate (300) comprises:
a silicon die (320) embedded within the package substrate (300), wherein the silicon die (320) has a front side that faces the integrated circuit die (202) and a back side opposing the front side; and
a conductive path that is electrically coupled to the silicon die (320) from the back side of the silicon die (320) wherein the package substrate (300) further comprises:
a conductive layer (510) on which the silicon die (320) is mounted, wherein the conductive path is connected to the conductive layer (510) and wherein the package substrate (300) further comprises:
a patterned adhesive layer (514) interposed between the silicon die (320) and the conductive layer (510) **characterized in that** a cavity (512) is included adjacent to the silicon die (320) in order to account for differences between the coefficient of thermal expansion between the silicon die (320) and package substrate (300).

2. The integrated circuit package as in claim 1, wherein the conductive path supplies power to the silicon die (320).

3. The integrated circuit package as in claim 1, further comprising:
an additional integrated circuit die that is mounted on the package substrate (300) and
that communicates with the integrated circuit die (202) through the silicon die (320).

4. The integrated circuit package as in claim 3, wherein the package substrate (300) further comprises:
a conductive pad (518) that is formed at the back side of the silicon die (320) and that is surrounded by the patterned adhesive layer (514).

5. The integrated circuit package as in claim 4, wherein the silicon die (320) comprises:
a conductive routing trace; and
a microvia that is coupled between the conductive routing trace and the conductive pad (518).

6. The integrated circuit package as in any one of claims 1, 4 or 5, wherein the conductive layer (510) includes a plurality of conductive regions that are electrically isolated from one another.

7. The integrated circuit package as in claim 6, wherein the plurality of conductive regions comprises at least two conductive regions biased to different voltage levels.

8. The integrated circuit package as in any one of claims 1-7, wherein the silicon die (320) comprises:
a plurality of through-silicon vias that extend from the back side to the front side of the silicon die (320).

9. The integrated circuit package as in claim 3, wherein the package substrate (300) further comprises: a first contact pad formed on the front side of the silicon die (320); a second contact pad formed on the back side of the silicon die (320); a first via that is directly connected to the first contact pad and that has a first diameter; and a second via that is coupled to the second contact pad and that has a second diameter that is different than the first diameter.

10. The integrated circuit package as in claim 9, wherein the second diameter is greater than the first diameter.

11. The integrated circuit package as in claim 10, wherein the package substrate (300) further comprises a conductive layer (510) on which the silicon die (320) is mounted, and wherein the silicon die (320) receives the power through the conductive layer (510).

12. The integrated circuit package as in claim 11, wherein the conductive layer (510) comprises a plurality of conductive regions that are each electrically isolated from one another and that are each biased to a respectively different voltage level.

13. The integrated circuit package as in any of claims 9-12, further comprising:
a printed circuit board, wherein the package substrate (300) is mounted on the printed circuit board, and the silicon die (320) receives the power from the printed circuit board.

## Patentansprüche

1. Integriertes Schaltungsgehäuse, das Folgendes umfasst:
ein Gehäusesubstrat (300); und
einen integrierten Schaltungs-Die (202), montiert auf dem Gehäusesubstrat (300), wobei das Gehäusesubstrat (300) Folgendes umfasst:
einen Silizium-Die (320), eingebettet in das Gehäusesubstrat (300), wobei der Silizium-Die (320) eine Vorderseite, die zum integrierten Schaltungs-Die (202) zeigt und eine der Vorderseite gegenüberliegende Rückseite aufweist; und
ein leitfähiger Pfad, der elektrisch mit dem Silizium-Die (320) von der Rückseite des Silizium-Dies (320) gekoppelt ist, wobei das Gehäusesubstrat (300) ferner Folgendes umfasst:
eine leitfähige Schicht (510), auf der der Silizium-Die (320) montiert ist, wobei der leitfähige Pfad mit der leitfähigen Schicht (510) verbunden ist und wobei das Gehäusesubstrat (300) ferner Folgendes umfasst:
eine strukturierte Klebstoffschicht (514), positioniert zwischen dem Silizium-Die (320) und der leitfähigen Schicht (510), **dadurch gekennzeichnet, dass** ein Hohlraum (512) angrenzend an den Silizium-Die (320) enthalten ist, um Unterschiede zwischen den Wärmeausdehnungskoeffizienten des Silizium-Dies (320) und des Gehäusesubstrats (300) zu berücksichtigen.

2. Integriertes Schaltungsgehäuse nach Anspruch 1, wobei der leitfähige Pfad Leistung zu dem Silizium-Die (320) zuführt.

3. Integriertes Schaltungsgehäuse nach Anspruch 1, das ferner Folgendes umfasst:
einen zusätzlichen integrierten Schaltungs-Die, der auf dem Gehäusesubstrat (300) montiert ist und der über den Silizium-Die (320) mit dem integrierten Schaltungs-Die (202) kommuniziert.

4. Integriertes Schaltungsgehäuse nach Anspruch 3, wobei das Gehäusesubstrat (300) ferner Folgendes umfasst:
ein leitfähiges Feld (518), das an der Rückseite des Silizium-Dies (320) gebildet ist und das von der strukturierten Klebstoffschicht (514) umgeben ist.

5. Integriertes Schaltungsgehäuse nach Anspruch 4, wobei der Silizium-Die (320) Folgendes umfasst:
eine leitfähige Führungsbahn; und
ein Mikrovia, das zwischen der leitfähigen Führungsbahn und dem leitfähigen Feld (518) gekoppelt ist.

6. Integriertes Schaltungsgehäuse nach einem der Ansprüche 1, 4 oder 5, wobei die leitfähige Schicht (510) mehrere leitfähige Regionen umfasst, die elektrisch voneinander isoliert sind.

7. Integriertes Schaltungsgehäuse nach Anspruch 6, wobei die mehreren leitfähigen Regionen mindestens zwei leitfähige Regionen, die auf unterschiedliche Spannungspegel vorgespannt sind, umfasst.

8. Integriertes Schaltungsgehäuse nach einem der Ansprüche 1-7, wobei der Silizium-Die (320) Folgendes umfasst:
mehrere Silizium-Durchkontaktierungen, die sich von der Rückseite zur Vorderseite des Silizium-Dies (320) erstrecken.

9. Integriertes Schaltungsgehäuse nach Anspruch 3, wobei das Gehäusesubstrat (300) ferner Folgendes umfasst:
ein erstes Kontaktfeld, ausgebildet an der Vorderseite des Silizium-Dies (320); ein zweites Kontaktfeld, ausgebildet an der Rückseite des Silizium-Dies (320);
eine erste Durchkontaktierung, die direkt mit dem ersten Kontaktfeld verbunden ist und einen ersten Durchmesser aufweist; und eine zweite Durchkontaktierung, die mit dem zweiten Kontaktfeld gekoppelt ist und die einen zweiten Durchmesser aufweist, der vom ersten Durchmesser verschieden ist.

10. Integriertes Schaltungsgehäuse nach Anspruch 9, wobei der zweite Durchmesser größer als der erste Durchmesser ist.

11. Integriertes Schaltungsgehäuse nach Anspruch 10, wobei das Gehäusesubstrat (300) ferner eine leitfähige Schicht (510) umfasst, auf der der Silizium-Die (320) montiert ist, und wobei der Silizium-Die (320) die Leistung über die leitfähige Schicht (510) empfängt.

12. Integriertes Schaltungsgehäuse nach Anspruch 11, wobei die leitfähige Schicht (510) mehrere leitfähige Regionen umfasst, die jeweils elektrisch voneinander isoliert sind und die jeweils auf einen unterschiedlichen Spannungspegel vorgespannt sind.

13. Integriertes Schaltungsgehäuse nach einem der Ansprüche 9-12, das ferner Folgendes umfasst:
eine Leiterplatte, wobei das Gehäusesubstrat (300) auf der Leiterplatte montiert ist, und wobei der Silizium-Die (320) die Leistung von der Leiterplatte empfängt.

## Revendications

1. Boîtier de circuit intégré, comprenant :
un substrat de boîtier (300) ; et
une puce de circuit intégré (202) montée sur le substrat de boîtier (300), le substrat de boîtier (300) comprenant :
une puce en silicium (320) incorporée à l'intérieur du substrat de boîtier (300), la puce en silicium (320) ayant un côté avant qui fait face à la puce de circuit intégré (202) et un côté arrière à l'opposé du côté avant ; et
une piste conductrice qui est couplée électriquement à la puce en silicium (320) depuis le côté arrière de la puce en silicium (320), le substrat de boîtier (300) comprenant en outre :
une couche conductrice (510) sur laquelle est montée la puce en silicium (320), la piste conductrice étant reliée à la couche conductrice (510), et le substrat de boîtier (300) comprenant en outre :
une couche d'adhésif à motif (514) intercalée entre la puce en silicium (320) et la couche conductrice (510), **caractérisé en ce qu'**une cavité (512) est ménagée au voisinage de la puce en silicium (320) afin de tenir compte de différences de coefficient de dilatation thermique entre la puce en silicium (320) et le substrat de boîtier (300).

2. Boîtier de circuit intégré selon la revendication 1, dans lequel la piste conductrice alimente électriquement la puce en silicium (320).

3. Boîtier de circuit intégré selon la revendication 1, comprenant en outre :
une puce de circuit intégré supplémentaire qui est montée sur le substrat de boîtier (300) et qui communique avec la puce de circuit intégré (202) par le biais de la puce en silicium (320).

4. Boîtier de circuit intégré selon la revendication 3, le substrat de boîtier (300) comprenant en outre :
un plot conducteur (518) qui est formé sur le côté arrière de la puce en silicium (320) et qui est entouré par la couche d'adhésif à motif (514).

5. Boîtier de circuit intégré selon la revendication 4, dans lequel la puce en silicium (320) comprend :
une trace de routage conductrice ; et
un microtrou d'interconnexion qui est couplé entre la trace de routage conductrice et le plot conducteur (518) .

6. Boîtier de circuit intégré selon l'une quelconque des revendications 1, 4 et 5, dans lequel la couche conductrice (510) comporte une pluralité de régions conductrices qui sont isolées électriquement les unes des autres.

7. Boîtier de circuit intégré selon la revendication 6, dans lequel la pluralité de régions conductrices comprend au moins deux régions conductrices polarisées à des niveaux de tension différents.

8. Boîtier de circuit intégré selon l'une quelconque des revendications 1 à 7, dans lequel la puce en silicium (320) comprend :
une pluralité de trous d'interconnexion à travers le silicium qui s'étendent du côté arrière au côté avant de la puce en silicium (320).

9. Boîtier de circuit intégré selon la revendication 3, le substrat de boîtier (300) comprenant en outre : un premier plot de contact formé sur le côté avant de la puce en silicium (320) ; un deuxième plot de contact formé sur le côté arrière de la puce en silicium (320) ; un premier trou d'interconnexion qui est directement relié au premier plot de contact et qui a un premier diamètre ; et un deuxième trou d'interconnexion qui est couplé au deuxième plot de contact et qui a un deuxième diamètre qui est différent du premier diamètre.

10. Boîtier de circuit intégré selon la revendication 9, dans lequel le deuxième diamètre est supérieur au premier diamètre.

11. Boîtier de circuit intégré selon la revendication 10, le substrat de boîtier (300) comprenant en outre une couche conductrice (510) sur laquelle est montée la puce en silicium (320), et dans lequel la puce en silicium (320) est alimentée électriquement par le biais de la couche conductrice (510).

12. Boîtier de circuit intégré selon la revendication 11, dans lequel la couche conductrice (510) comprend une pluralité de régions conductrices qui sont isolées électriquement les unes des autres et qui sont chacune polarisées à un niveau de tension respectivement différent.

13. Boîtier de circuit intégré selon l'une quelconque des revendications 9 à 12, comprenant en outre :
un circuit imprimé nu, le substrat de boîtier (300) étant monté sur le circuit imprimé nu, et la puce en silicium (320) étant alimentée électriquement depuis le circuit imprimé nu.
